# EUROPEAN PATENT SPECIFICATION

(11) **EP 4 309 088 B1**
(45) Date of publication and mention of the grant of the patent: **23.10.2024**
(21) Application number: 22712721.4
(22) Date of filing: 07.03.2022
(51) Int. Cl.: G06N 10/00, G06N 10/40, H10N 69/00

(54) **VAN DER WAALS CAPACITOR AND QUBIT USING THE SAME**
VAN-DER-WAALS-KONDENSATOR UND QUBIT MIT DIESEM KONDENSATOR
CONDENSATEUR DE VAN DER WAALS ET QUBIT L'UTILISANT

(30) Priority: 16.03.2021 US 202163161891 P; 04.03.2022 US 202217686832
(43) Date of publication of application: 24.01.2024
(73) Proprietor: RTX BBN Technologies, Inc., Cambridge, MA 02138 (US); Columbia University, New York, NY 10027 (US)
(72) Inventor: WARE, Matthew Elliot, Arlington, Massachusetts 02474 (US); RAJENDRAN, Anjaly Thekkevilayil, New York, New York 10027 (US); RIBEILL, Guilhem Jean Antoine, Arlington, Massachusetts 02474 (US); OHKI, Thomas Akira, Arlington, Massachusetts 02474 (US); HONE, James Curtis, New York, New York 10027 (US); GUSTAFSSON, Martin, Cambridge, Massachusetts 02138 (US); GOVIA, Luke, Somerville, Massachusetts 02145 (US); FONG, Kin Chung, Concord, Massachusetts 01742 (US); ANTONY, Abhinandan, New York, New York 10025 (US)
(74) Representative: Dentons UK and Middle East LLP
(86) International application number: PCT/US2022/019199
(87) International publication number: WO 2022/197482

(56) References cited:
- WO-A1-2018/160187
- JOEL I-JAN WANG ET AL: "Quantum coherent control of a hybrid superconducting circuit made with graphene-based van der Waals heterostructures", ARXIV.ORG, CORNELL UNIVERSITY LIBRARY, 201 OLIN LIBRARY CORNELL UNIVERSITY ITHACA, NY 14853, 14 September 2018 (2018-09-14), XP080999156, DOI: 10.1038/S41565-018-0329-2
- ABHINANDAN ANTONY ET AL: "Miniaturizing transmon qubits using van der Waals materials", ARXIV.ORG, CORNELL UNIVERSITY LIBRARY, 201 OLIN LIBRARY CORNELL UNIVERSITY ITHACA, NY 14853, 14 May 2022 (2022-05-14), XP091214798, DOI: 10.1021/ACS.NANOLETT.1C04160
- JIFA TIAN ET AL: "A Josephson junction with h-BN tunnel barrier: observation of low critical current noise", JOURNAL OF PHYSICS: CONDENSED MATTER, INSTITUTE OF PHYSICS PUBLISHING, BRISTOL, GB, vol. 33, no. 49, 1 October 2021 (2021-10-01), pages 495301, XP020371951, ISSN: 0953-8984, [retrieved on 20211001], DOI: 10.1088/1361-648X/AC268F

## Description

### FIELD

One or more aspects of embodiments according to the present disclosure relate to capacitors, and more particularly to a capacitor for use in a quantum bit (qubit).

### BACKGROUND

A transmission line shunted plasma oscillation qubit (transmon qubit) may be fabricated with one or two Jacobsen junctions and a capacitor connected in parallel with one or both Jacobsen junctions. In such a system, performance may be enhanced if the capacitor has relatively low loss. A capacitor design in which the electric field lines pass through (i) a substrate to air interface, (ii) a metal to air interface, or (iii) a substrate to metal interface may however exhibit significant loss as a result of imperfections or impurities at the interfaces.

It is with respect to this general technical environment that aspects of the present disclosure are related.

WO 2018/160187 A1 discloses a superconducting qubit device with hexagonal boron nitride Josephson junctions.

Joel I-Jan Wang et al., Arxiv.org, Cornell University Library, 201 Onlin Library Cornell University Ithaca, NY 14853, 14 September 2018, disclose quantum coherent control of a hybrid superconducting circuit made with graphene-based van der Waals heterostrucutres.

### SUMMARY

According to an embodiment of the present disclosure, there is provided a capacitor, including: a first conductive layer; an insulating layer, on the first conductive layer; and a second conductive layer on the insulating layer, the first conductive layer being composed of one or more layers of a first van der Waals material, the insulating layer being composed of one or more layers of a second van der Waals material, and the second conductive layer being composed of one or more layers of a third van der Waals material.

In some embodiments, the capacitor further includes: an insulating lower layer, under the first conductive layer; and an insulating upper layer, on the second conductive layer, wherein: the insulating lower layer being composed of one or more layers of a first van der Waals material, and the insulating upper layer being composed of one or more layers of a first van der Waals material.

In some embodiments, the capacitor further includes: a first layer of graphene, between the first conductive layer and the insulating layer; and a second layer of graphene, between the insulating layer and the second conductive layer.

In some embodiments, the first conductive layer is a superconducting layer and the second conductive layer is a superconducting layer.

In some embodiments, the first van der Waals material is a material selected from the group consisting of NbSe₂, MoTe₂, WTe₂, TaS₂, BSCCO, graphene, and combinations thereof.

In some embodiments, the third van der Waals material is the same material as the first van der Waals material.

In some embodiments, the second van der Waals material is a material selected from the group consisting of BN, WSe₂, MoS₂, MoSe₂, WS₂, MoTe₂, PtS₂, PtSe₂, PtTe₂, HfS₂, HfSe₂, ReS₂, ReSe₂, SnS₃, SnSe₂, ZrS₂, ZrSe₂, silicene, germanene, black phosphorus, and combinations thereof.

In some embodiments, the capacitor further includes: a first electrode, in contact with the first conductive layer, and a second electrode, in contact with the second conductive layer.

In some embodiments, the first electrode is composed of a superconducting material.

In some embodiments, the first electrode is composed of a material selected from the group consisting of aluminum, niobium, niobium nitride, niobium titanium nitride, titanium nitride, and molybdenum rhenium.

According to an embodiment of the present disclosure, there is provided a quantum bit, including: a capacitor according to claim 1, and a Josephson junction, connected to the capacitor.

In some embodiments, the quantum bit further includes: an insulating lower layer, under the first conductive layer; and an insulating upper layer, on the second conductive layer, wherein: the insulating lower layer being composed of one or more layers of a first van der Waals material, and the insulating upper layer being composed of one or more layers of a first van der Waals material.

In some embodiments, the quantum bit further includes: a first layer of graphene, between the first conductive layer and the insulating layer; and a second layer of graphene, between the insulating layer and the second conductive layer.

In some embodiments, the first conductive layer is a superconducting layer and the second conductive layer is a superconducting layer.

In some embodiments, the first van der Waals material is a material selected from the group consisting of NbSe₂, MoTe₂, WTe₂, TaS₂, BSCCO, graphene, and combinations thereof.

In some embodiments, the third van der Waals material is the same material as the first van der Waals material.

In some embodiments, the second van der Waals material is a material selected from the group consisting of BN, WSe₂, MoS₂, MoSe₂, WS₂, MoTe₂, PtS₂, PtSe₂, PtTe₂, HfS₂, HfSe₂, ReS₂, ReSe₂, SnS₃, SnSe₂, ZrS₂, ZrSe₂, silicene, germanene, black phosphorus, and combinations thereof.

In some embodiments, the quantum bit further includes: a first electrode, in contact with the first conductive layer, and a second electrode, in contact with the second conductive layer.

In some embodiments, the first electrode is composed of a superconducting material.

In some embodiments, the first electrode is composed of a material selected from the group consisting of aluminum, niobium, niobium nitride, niobium titanium nitride, titanium nitride, and molybdenum rhenium.

### BRIEF DESCRIPTION OF THE DRAWINGS

Features, aspects, and embodiments are described in conjunction with the attached drawings, in which:
FIG. 1 is a schematic drawing of a qubit, according to an embodiment of the present disclosure;
FIG. 2 is a schematic drawing of a capacitor, according to an embodiment of the present disclosure;
FIG. 3 is a schematic drawing of a capacitor, according to an embodiment of the present disclosure;
FIG. 4A is a schematic drawing of test coupon, according to an embodiment of the present disclosure;
FIG. 4B is a schematic drawing of test coupon, according to an embodiment of the present disclosure;
FIG. 4C is a schematic drawing of test coupon, according to an embodiment of the present disclosure;
FIG. 4D is a schematic drawing of test coupon, according to an embodiment of the present disclosure;
FIG. 5 is a schematic diagram of a qubit, according to an embodiment of the present disclosure;
FIG. 6 is a schematic drawing of a capacitor, according to an embodiment of the present disclosure;
FIG. 7A is a photograph of a qubit circuit, according to an embodiment of the present disclosure; and
FIG. 7B is an enlarged view of a portion of FIG. 7A.

### DETAILED DESCRIPTION

The detailed description set forth below in connection with the appended drawings is intended as a description of exemplary embodiments of a van der Waals capacitor and a qubit constructed with such a capacitor provided in accordance with the present disclosure and is not intended to represent the only forms in which some embodiments may be constructed or utilized. The description sets forth the features of the present disclosure in connection with the illustrated embodiments. It is to be understood, however, that the same or equivalent functions and structures may be accomplished by different embodiments that are also intended to be encompassed within the scope of the disclosure. As denoted elsewhere herein, like element numbers are intended to indicate like elements or features.

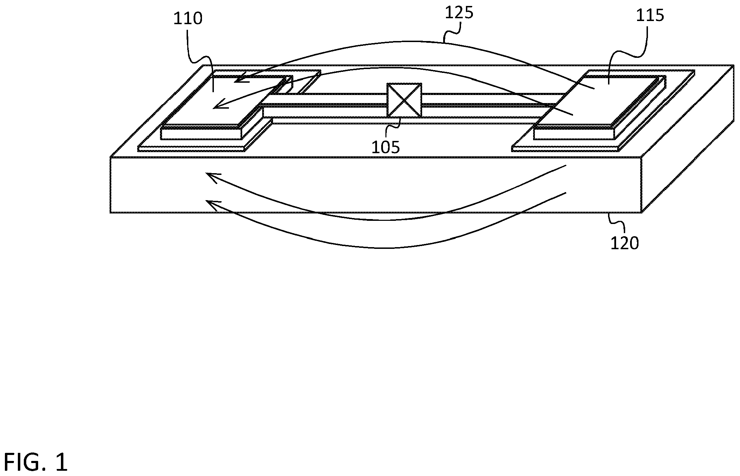

FIG. 1 shows a quantum bit, or "qubit", in some embodiments. The quantum bit may be characterized by two quantum mechanical states, separated by an energy difference. A Josephson junction 105 is connected between a first metal (e.g. superconducting metal) pad 110 and a second metal (e.g. superconducting metal) pad 115. In operation, the first metal pad 110 and the second metal pad 115 form a capacitor connected in parallel with the Josephson junction 105. The structure may be fabricated on a substrate 120. Exemplary electric field lines 125, between a first charge on the first metal pad 110 and a second charge on the second metal pad 115, are shown. These field lines may cross (i) a substrate to air interface, (ii) a metal to air interface, and (iii) a substrate to metal interface, at one or more points. At these interfaces, impurities or other imperfections may give rise to two-level systems having respective energy differences similar to that of the qubit; these two-level systems may interact with the qubit, resulting in loss and a degradation in performance.

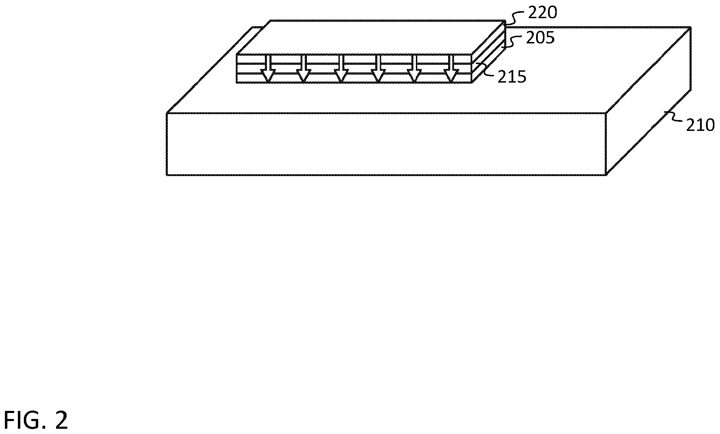

In some embodiments, a capacitor is instead formed as a stack of layers of van der Waals materials, as illustrated in FIG. 2. The capacitor includes a first conductive layer 205 on a substrate 210, an insulating layer 215, on the first conductive layer 205, and a second conductive layer 220 on the insulating layer 215. The first conductive layer 205 may be composed of one or more layers of a first van der Waals material, the insulating layer 215 may be composed of one or more layers of a second van der Waals material, and the second conductive layer 220 may be composed of one or more layers of a third van der Waals material. The third van der Waals material may be the same material as the first van der Waals material. Exemplary electric field lines 225 are shown. Except for fringing fields (not shown) each line of electric field extends directly from the second conductive layer 220 to the first conductive layer 205, passing through (i) a first interface between the second conductive layer 220 and the insulating layer 215 and (ii) a second interface between the first conductive layer 205 and the insulating layer 215. These interfaces may be significantly cleaner than the substrate to air interface, the metal to air interface, and the substrate to metal interface of the embodiment of FIG. 1. Although other interfaces (e.g., an air to substrate interface) are present in the embodiment of FIG. 2, the coupling of the capacitor to these interfaces may be relatively weak because only fringing fields may interact with these interfaces. Moreover, the capacitor of the embodiment of FIG. 2 may be significantly smaller (e.g., up to a factor of 1000 smaller) than the structure of FIG. 1.

The first conductive layer 205 and the second conductive layer 220 may be superconducting layers, e.g., at sufficiently low temperature, current density, and magnetic field, each of the first conductive layer 205 and the second conductive layer 220 may be in a superconducting state.

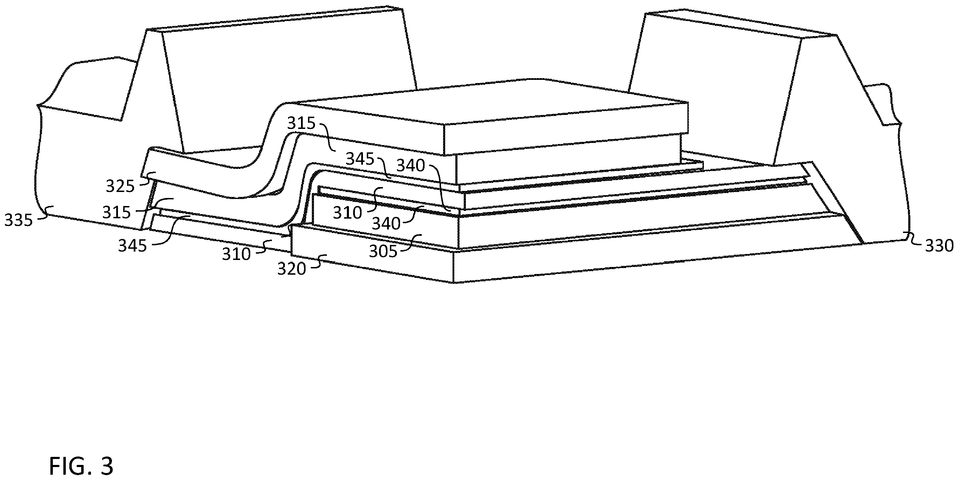

FIG. 3 shows a capacitor, in some embodiments. As in the embodiment of FIG. 2, the capacitor includes a first conductive layer 305, an insulating layer 310 on the first conductive layer 305, and a second conductive layer 315 on the insulating layer 310. The capacitor of the embodiment of FIG. 3 further includes an insulating lower layer 320 between the substrate (not shown) and the first conductive layer 305, and an insulating upper layer 325 on the second conductive layer 315. The substrate may be a wafer of high-purity silicon (e.g., flow-zone silicon). In the embodiment of FIG. 3, the capacitor further includes a first electrode 330 and a second electrode 335, each of which may be a superconducting (e.g. aluminum) electrode. As used herein, a material or structure may be said to be "superconducting" if, at sufficiently low temperature, current density, and magnetic field it will be in, or it will transition to, a superconducting state. As used herein, this term ("superconducting") also applies to the structure or material when it is not in a superconducting state. As such, aluminum, or an aluminum electrode, may be referred to as "superconducting", even when it is at room temperature (and not in a superconducting state).

In some embodiments, the capacitor further includes a lower layer of graphene 340, between the first conductive layer 305 and the insulating layer 310, and an upper layer of graphene 345 between the insulating layer 310 and the second conductive layer 315. The lower layer of graphene 340 and the upper layer of graphene 345 may be superconducting layers as a result of being proximitized to the first conductive layer 305 and to the second conductive layer 315 respectively. In some embodiments, the lower layer of graphene 340 and the upper layer of graphene 345 are absent.

As in the embodiment of FIG. 2, each of (i) the first conductive layer 305, the insulating layer 310, and the second conductive layer 315 may be composed of a van der Waals material. For example, each of the first conductive layer 305 and the second conductive layer 315 may be composed of niobium selenide (NbSe₂), molybdenum telluride (MoTe₂), tungsten telluride (WTe₂), tantalum sulfide (TaS₂), bismuth strontium calcium copper oxide (BSCCO), combinations (e.g., alloys) of these materials, or one of various thicknesses and twist angles of graphene. The insulating layer 310 may be composed of boron nitride (BN), tungsten selenide (WSe₂), molybdenum sulfide (MoS₂), MoSe₂, WS₂, MoTe₂, PtS₂, PtSe₂, PtTe₂, HfS₂, HfSe₂, ReS₂, ReSe₂, SnS₃, SnSe₂, ZrS₂, ZrSe₂, silicene, germanene, or black phosphorus. In other embodiments, other suitable conducting (e.g., superconducting) or insulating materials may be used, respectively. In some embodiments, the insulating layer 310 includes fewer than 100 monolayers; the low thickness of this layer may result in a high capacitance per unit area of the capacitor. In some embodiments the insulating layer 310 includes fewer than 10 (e.g., as few as one or two) monolayers; the thickness may be selected to be the smallest thickness for which the tunneling effect is negligible or acceptably small. In some embodiments, the insulating lower layer 320 and the insulating upper layer 325 may also be composed of a van der Waals material (e.g., BN, WSe2, MoSe2, or MoS2).

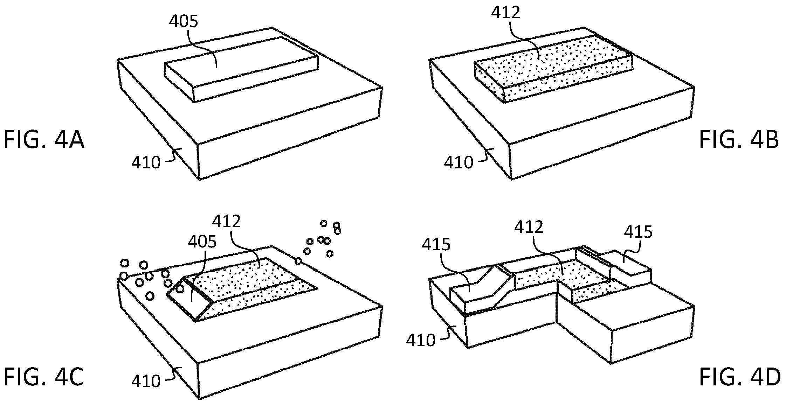

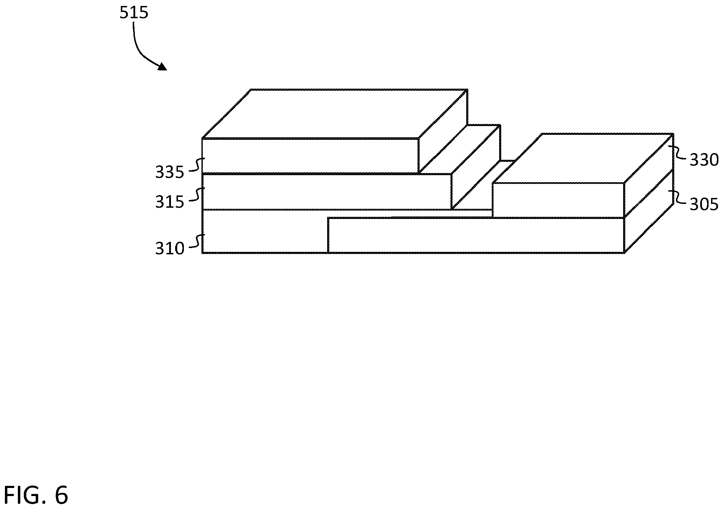

FIGs. 4A - 4D show a portion of a process for fabricating electrodes in contact with a conducting layer. FIGs. 4A - 4D show, for ease of illustration, the process of forming electrodes 415 on a layer of niobium selenide 405 on a test coupon which initially includes only the layer of niobium selenide 405 on the substrate 410; in some embodiments an analogous process may be used to form electrodes that are in contact with the first conductive layer 305 and with the second conductive layer 315 of a capacitor (e.g., the capacitor of FIG. 3 or the capacitor of FIG. 6 (discussed in further detail below)). A layer of niobium selenide 405 (e.g., niobium diselenide, NbSe2) is deposited (e.g., on a substrate 410, as shown in FIG. 4A). The test coupon is then moved to an evaporating chamber for the forming of electrodes; during the process of moving the test coupon, the outer surface of the layer of niobium selenide 405 may (as shown in FIG. 4B) become oxidized (e.g. covered with an oxide coating 412, shown in FIGs. 4B - 4D as a stippled surface) result of exposure to atmospheric oxygen. Ion milling may then be used, as shown in FIG. 4C, to remove a portion of the layer of niobium selenide 405, exposing unoxidized niobium selenide 405, and electrodes 415 may be formed on the exposed unoxidized niobium selenide 405 as shown in FIG. 4D. FIG. 4D is a cutaway view showing the unoxidized niobium selenide below the layer of oxide, and in contact with the electrodes 415.

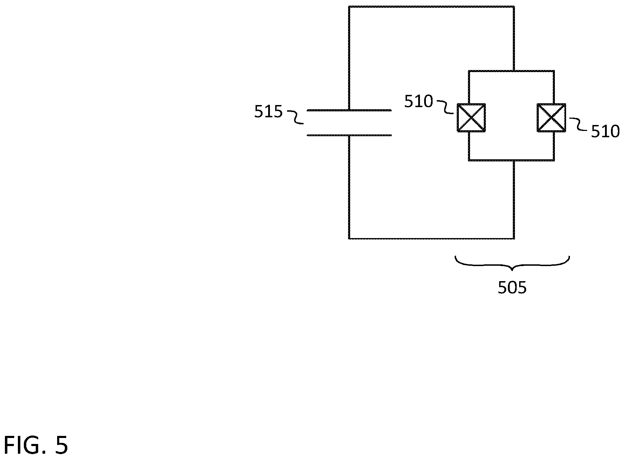

FIG. 5 shows a tunable frequency transmon qubit, which includes (i) a superconducting quantum interference device (SQUID) 505 including two Josephson junctions 510 connected in a loop, and (ii) a capacitor 515 (e.g., the capacitor of FIG. 3 or the capacitor of FIG. 6 (discussed in further detail below)), connected in parallel with the SQUID 505. In some embodiments, a fixed frequency transmon qubit (having, instead of the SQUID 505, a single Josephson junction 510, connected in parallel with the capacitor 515) may be constructed in an analogous manner.

FIG. 6 is a schematic drawing of a capacitor 515, in some embodiments. The capacitor 515 includes (like the capacitor of the embodiment of FIG. 3) a first conductive layer 305, an insulating layer 310, on the first conductive layer 305, and a second conductive layer 315 on the insulating layer 310. The capacitor further includes a first electrode 330 and a second electrode 335, in contact with the first conductive layer 305 and the second conductive layer 315, respectively. The capacitor of the embodiment of FIG. 6 lacks the insulating lower layer 320, the insulating upper layer 325, the lower layer of graphene 340, and the upper layer of graphene 345 that are shown for the capacitor of the embodiment of FIG. 3.

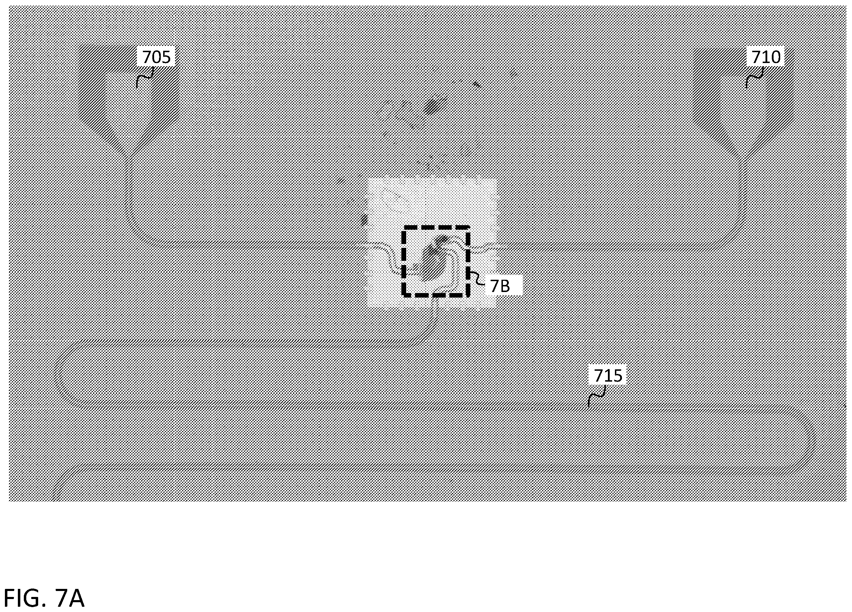

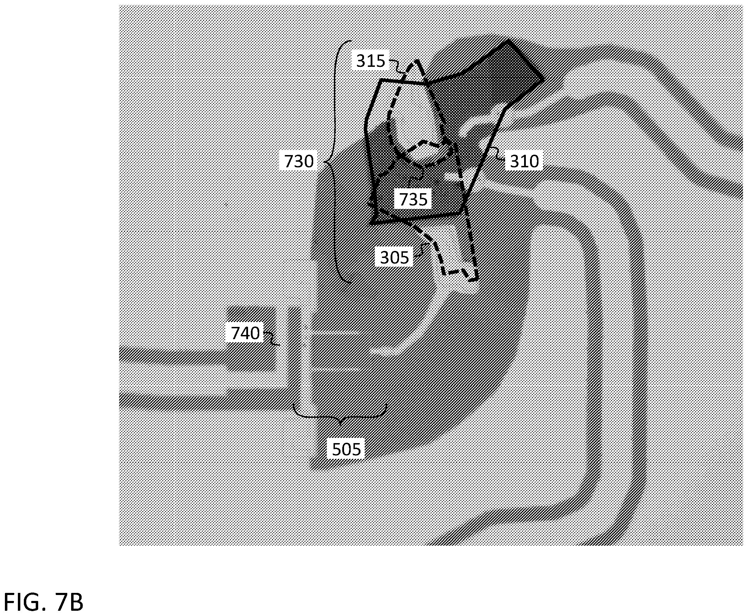

FIGs. 7A is a photograph of a reduction to practice, in one embodiment, of a qubit including a capacitor according to embodiments described herein. FIG. 7B is an enlarged view of a portion (labeled "7B") of FIG. 7A. The circuit may be fabricated on a silicon (e.g., float-zone silicon) substrate, or wafer. FIG. 7A shows three external connections to the qubit, which is illustrated in FIG. 7B. A first wire bond pad 705 is terminated to ground at a point adjacent to the qubit. A bias current supplied through the first wire bond pad 705 may be employed to produce a magnetic field at the qubit, to control the critical current of the SQUID loop of the qubit, and to control the frequency of the qubit. A second wire bond pad 710 may be capacitively coupled to the SQUID. Control pulses may be sent to the qubit via the second wire bond pad 710 to control the state of the qubit (e.g., to rotate the state of the qubit in the Bloch sphere). The third connection illustrated in FIG. 7A is a microwave resonator 715, which may be employed to read out the qubit. The microwave resonator 715 and the connections to the first wire bond pad 705 and to the second wire bond pad 710 may each be constructed as a coplanar microwave waveguide.

FIG. 7B shows, as mentioned above, an enlarged view of the qubit of FIG. 7A. The capacitor 730 includes a first conductive layer 305 (e.g., a layer of niobium diselenide), an insulating layer 310 (e.g., a layer of boron nitride (e.g., of hexagonal boron nitride)), and a second conductive layer 315 (e.g., a layer of niobium diselenide). The capacitance of the capacitor is largely determined by an area of overlap 735, within which each of the first conductive layer 305, the insulating layer 310, and the second conductive layer 315 is present. The capacitor is connected to a SQUID 505, the magnetic field in which may be controlled by adjusting the current flowing in a conductive segment 740 (which may be connected to the first wire bond pad 705 through a coplanar microwave waveguide).

The capacitor 730 of FIGs. 7A and 7B may be fabricated as follows. The first conductive layer 305 may be exfoliated from a niobium diselenide bulk crystal using a suitable adhesive exfoliating tool, and transferred to the bare silicon substrate. The insulating layer 310 may then be exfoliated from a boron nitride bulk crystal, and placed in a position partially overlapping the first conductive layer 305 (and leaving a portion of the first conductive layer 305 exposed), and the second conductive layer 315 may then be exfoliated from a niobium diselenide bulk crystal and placed on the substrate, such that a portion of the second conductive layer 315 overlaps the region in which the insulating layer 310 overlaps the first conductive layer 305. Electrodes (e.g., aluminum electrodes) may then be fabricated to contact the first conductive layer 305 (e.g., the exposed portion of the first conductive layer 305) and the second conductive layer 315.

The fabrication of the electrodes may include (i) forming a layer of photoresist over the wafer, (ii) patterning the photoresist (e.g., using e-beam lithography) to remove the photoresist in areas in which metal (e.g., aluminum) is to be deposited, (iii) depositing a layer of metal (e.g., aluminum) over the wafer, and (iv) removing the photoresist and the portions of the metal layer that are on photoresist, using a lift-off process. The conductors forming the external connections (e.g., the first wire bond pad 705, the second wire bond pad 710, the coplanar waveguides connected to them, and the microwave resonator 715) may be formed at the same time. Because the shapes of the exfoliated layers may be unpredictable (e.g., they may vary from one exfoliation operation to another), the shape of the metal (e.g., aluminum) layer to be formed may be designed after the first conductive layer 305, the insulating layer 310, and the second conductive layer 315 have been placed on the substrate. The SQUID 505 may be fabricated before or after the capacitor.

As used herein, "a portion of" something means "at least some of" the thing, and as such may mean less than all of, or all of, the thing. As such, "a portion of" a thing includes the entire thing as a special case, i.e., the entire thing is an example of a portion of the thing. As used herein, the word "or" is inclusive, so that, for example, "A or B" means any one of (i) A, (ii) B, and (iii) A and B.

It will be understood that when a layer is referred to as being "between" two layers, it can be the only layer between the two layers, or one or more intervening layers may also be present. The terminology used herein is for the purpose of describing particular embodiments only and is not intended to be limiting of the inventive concept. As used herein, the terms "substantially," "about," and similar terms are used as terms of approximation and not as terms of degree, and are intended to account for the inherent deviations in measured or calculated values that would be recognized by those of ordinary skill in the art.

As used herein, the term "major component" refers to a component that is present in a composition, polymer, or product in an amount greater than an amount of any other single component in the composition or product. In contrast, the term "primary component" refers to a component that makes up at least 50% by weight or more of the composition, polymer, or product. As used herein, the term "major portion", when applied to a plurality of items, means at least half of the items. As used herein, any structure or layer that is described as being "made of" or "composed of" a substance should be understood (i) in some embodiments, to contain that substance as the primary component or (ii) in some embodiments, to contain that substance as the major component. It will be understood that when an element or layer is referred to as being "on", "connected to", "coupled to", or "adjacent to" another element or layer, it may be directly on, connected to, coupled to, or adjacent to the other element or layer, or one or more intervening elements or layers may be present. In contrast, when an element or layer is referred to as being "directly on", "directly connected to", "directly coupled to", or "immediately adjacent to" another element or layer, there are no intervening elements or layers present.

It will be understood that when an element is referred to as being "directly connected" or "directly coupled" to another element, there are no intervening elements present. As used herein, "generally connected" means connected by an electrical path that may contain arbitrary intervening elements, including intervening elements the presence of which qualitatively changes the behavior of the circuit. As used herein, "connected" means (i) "directly connected" or (ii) connected with intervening elements, the intervening elements being ones (e.g., low-value resistors or inductors, or short sections of transmission line) that do not qualitatively affect the behavior of the circuit.

Although limited embodiments of a van der Waals capacitor and a qubit constructed with such a capacitor have been specifically described and illustrated herein, many modifications and variations will be apparent to those skilled in the art.

## Claims

1. A capacitor (515, 730), comprising:
a first conductive layer (205, 305);
an insulating layer (215, 310), on the first conductive layer (205, 305); and
a second conductive layer (220, 315) on the insulating layer (215, 310),
the first conductive layer (205, 305) being composed of one or more layers of a first van der Waals material,
the insulating layer (215, 310) being composed of one or more layers of a second van der Waals material, and
the second conductive layer (220, 315) being composed of one or more layers of a third van der Waals material.

2. The capacitor (515, 730) of claim 1, further comprising:
an insulating lower layer, under the first conductive layer (205, 305); and
an insulating upper layer, on the second conductive layer (220, 315),
wherein:
the insulating lower layer being composed of one or more layers of a first van der Waals material, and
the insulating upper layer being composed of one or more layers of a first van der Waals material, optionally further comprising:
a first layer of graphene, between the first conductive layer (205, 305) and the insulating layer (215, 310); and
a second layer of graphene, between the insulating layer (215, 310) and the second conductive layer (220, 315).

3. The capacitor (515, 730) of any of claims 1-2, wherein the first conductive layer (205, 305) is a superconducting layer and the second conductive layer (220, 315) is a superconducting layer.

4. The capacitor (515, 730) of any of claims 1-3, wherein the first van der Waals material is a material selected from the group consisting of NbSe₂, MoTe₂, WTe₂, TaS₂, BSCCO, graphene, and combinations thereof.

5. The capacitor (515, 730) of any of claims 1-4, wherein the third van der Waals material is the same material as the first van der Waals material.

6. The capacitor (515, 730) of any of claims 1-5, wherein the second van der Waals material is a material selected from the group consisting of BN, WSe₂, MoS₂, MoSe₂, WS₂, MoTe₂, PtS₂, PtSe₂, PtTe₂, HfS₂, HfSe₂, ReS₂, ReSe₂, SnS₃, SnSe₂, ZrS₂,
ZrSe₂, silicene, germanene, black phosphorus, and combinations thereof.

7. The capacitor (515, 730) of any of claims 1-6, further comprising:
a first electrode, in contact with the first conductive layer (205, 305), and
a second electrode, in contact with the second conductive layer (220, 315), wherein optionally the first electrode is composed of a superconducting material, wherein more optionally the first electrode is composed of a material selected from the group consisting of aluminum, niobium, niobium nitride, niobium titanium nitride, titanium nitride, and molybdenum rhenium.

8. A quantum bit, comprising:
a capacitor (515, 730) according to claim 1, and
a Josephson junction, connected to the capacitor (515, 730).

9. The quantum bit of claim 8, further comprising:
an insulating lower layer, under the first conductive layer (205, 305); and
an insulating upper layer, on the second conductive layer (220, 315),
wherein:
the insulating lower layer being composed of one or more layers of a first van der Waals material, and
the insulating upper layer being composed of one or more layers of a first van der Waals material.

10. The quantum bit of any of claims 8-9, further comprising:
a first layer of graphene, between the first conductive layer (205, 305) and the insulating layer (215, 310); and
a second layer of graphene, between the insulating layer (215, 310) and the second conductive layer (220, 315), or wherein the first conductive layer (205, 305) is a superconducting layer and the second conductive layer (220, 315) is a superconducting layer, or wherein the first van der Waals material is a material selected from the group consisting of NbSe₂, MoTe₂, WTe₂, TaS₂, BSCCO, graphene, and combinations thereof, or wherein the third van der Waals material is the same material as the first van der Waals material.

11. The quantum bit of any of claims 8-10, wherein the second van der Waals material is a material selected from the group consisting of BN, WSe₂, MoS₂, MoSe₂, WS₂, MoTe₂, PtS₂, PtSe₂, PtTe₂, HfS₂, HfSe₂, ReS₂, ReSe₂, SnS₃, SnSe₂, ZrS₂, ZrSe₂, silicene, germanene, black phosphorus, and combinations thereof.

12. The quantum bit of any of claims 8-10, further comprising:
a first electrode, in contact with the first conductive layer (205, 305), and
a second electrode, in contact with the second conductive layer (220, 315).

13. The quantum bit of claim 12, wherein the first electrode is composed of a superconducting material.

14. The quantum bit of claim 13, wherein the first electrode is composed of a material selected from the group consisting of aluminum, niobium, niobium nitride, niobium titanium nitride, titanium nitride, and molybdenum rhenium.

## Patentansprüche

1. Ein Kondensator (515, 730), Folgendes umfassend:
eine erste leitende Schicht (205, 305);
eine Isolierschicht (215, 310) auf der ersten leitenden Schicht (205, 305); und
eine zweite leitende Schicht (220, 315) auf der Isolierschicht (215, 310),
wobei die erste leitende Schicht (205, 305) aus einer oder
mehreren Schichten eines ersten Van-der-Waals-Materials besteht,
die Isolierschicht (215, 310) aus einer oder mehreren Schichten eines zweiten Van-der-Waals-Materials besteht, und
wobei die zweite leitende Schicht (220, 315) aus einer oder
mehreren Schichten eines dritten Van-der-Waals-Materials besteht.

2. Der Kondensator (515, 730) nach Anspruch 1, ferner umfassend:
eine untere Isolierschicht unter der ersten leitenden Schicht (205, 305); und
eine obere Isolierschicht auf der zweiten leitenden Schicht (220, 315), wobei:
die untere Isolierschicht aus einer oder mehreren Schichten eines ersten Van-der-Waals-Materials besteht, und
die obere Isolierschicht aus einer oder mehreren Schichten eines ersten Van-der-Waals-Materials besteht, gegebenenfalls ferner umfassend:
eine erste Graphenschicht zwischen der ersten leitenden Schicht (205, 305) und der Isolierschicht (215, 310); und
eine zweite Graphenschicht zwischen der Isolierschicht (215, 310) und der zweiten leitenden Schicht (220, 315).

3. Kondensator (515, 730) nach einem der Ansprüche 1 bis 2, wobei die erste leitende Schicht (205, 305) eine supraleitende Schicht ist und die zweite leitende Schicht (220, 315) eine supraleitende Schicht ist.

4. Kondensator (515, 730) nach einem der Ansprüche 1 bis 3, wobei das erste Van-der-Waals-Material ein Material ist, das aus der Gruppe bestehend aus NbSe₂, MoTe₂, WTe₂, TaS2, BSCCO, Graphen und Kombinationen davon ausgewählt ist.

5. Kondensator (515, 730) nach einem der Ansprüche 1 bis 4, wobei das dritte Van-der-Waals-Material das gleiche Material wie das erste Van-der-Waals-Material ist.

6. Kondensator (515, 730) nach einem der Ansprüche 1 bis 5, wobei das zweite Van-der-Waals-Material ein Material ist, das aus der Gruppe bestehend aus BN, WSe₂,
MoS₂, MoSe₂, WS₂, MoTe₂, PtS₂, PtSe₂, PtTe₂, HfS₂, HfSe₂, ReS₂, ReSe₂, SnS₃, SnSe₂, ZrS₂, ZrSe₂, Silicen, Germanen, schwarzem Phosphor und Kombinationen davon ausgewählt ist.

7. Kondensator (515, 730) nach einem der Ansprüche 1 bis 6, ferner umfassend: eine erste Elektrode, die in Kontakt mit der ersten leitenden Schicht (205, 305) steht, und eine zweite Elektrode, die in Kontakt mit der zweiten leitenden Schicht (220, 315) steht, wobei die erste Elektrode optional aus einem supraleitenden Material besteht, wobei die erste Elektrode optional aus einem Material besteht, das aus der Gruppe bestehend aus Aluminium, Niob, Niobnitrid, Niobtitannitrid, Titannitrid und Molybdän-Rhenium ausgewählt ist.

8. Ein Quantenbit, umfassend:
einen Kondensator (515, 730) nach Anspruch 1, und
ein Josephson-Kontakt, der mit dem Kondensator (515, 730) verbunden ist.

9. Das Quantenbit nach Anspruch 8, ferner umfassend:
eine untere Isolierschicht unter der ersten leitenden Schicht (205, 305); und eine obere Isolierschicht auf der zweiten leitenden Schicht (220, 315), wobei:
die untere Isolierschicht aus einer oder mehreren Schichten eines ersten Van-der-Waals-Materials besteht, und
wobei die obere Isolierschicht aus einer oder mehreren Schichten eines ersten Van-der-Waals-Materials besteht.

10. Das Quantenbit nach einem der Ansprüche 8 bis 9, ferner umfassend:
eine erste Graphenschicht zwischen der ersten leitenden Schicht (205, 305) und der Isolierschicht (215, 310); und
eine zweite Graphenschicht zwischen der Isolierschicht (215, 310) und der zweiten leitenden Schicht (220, 315), oder wobei die erste leitende Schicht (205, 305) eine supraleitende Schicht ist und die zweite leitende Schicht (220, 315) eine supraleitende Schicht ist, oder wobei das erste Van-der-Waals-Material ein Material ist, das aus der Gruppe bestehend aus NbSe₂, MoTe₂, WTe₂, TaS₂, BSCCO, Graphen und Kombinationen davon ausgewählt ist, oder wobei das dritte Van-der-Waals-Material das gleiche Material wie das erste Van-der-Waals-Material ist.

11. Quantenbit nach einem der Ansprüche 8 bis 10, wobei das zweite Van-der-Waals-Material ein Material ist, das aus der Gruppe bestehend aus BN, WSe₂, MoS₂,
MoSe₂, WS₂, MoTe₂, PtS₂, PtSe₂, PtTe₂, HfS₂, HfSe₂, ReS₂, ReSe₂, SnS₃, SnSe₂, ZrS₂, ZrSe₂, Silicen, Germanen, schwarzem Phosphor und Kombinationen davon ausgewählt ist.

12. Das Quantenbit nach einem der Ansprüche 8 bis 10, ferner umfassend:
eine erste Elektrode, die in Kontakt mit der ersten leitenden Schicht (205, 305) steht, und
eine zweite Elektrode, die in Kontakt mit der zweiten leitenden Schicht (220, 315) steht.

13. Das Quantenbit nach Anspruch 12, wobei die erste Elektrode aus einem supraleitenden Material besteht.

14. Quantenbit nach Anspruch 13, wobei die erste Elektrode aus einem Material besteht, das aus der Gruppe bestehend aus Aluminium, Niob, Niobnitrid, Niobtitannitrid, Titannitrid und Molybdän-Rhenium ausgewählt ist.

## Revendications

1. Condensateur (515, 730), comprenant :
une première couche conductrice (205, 305) ;
une couche isolante (215, 310), sur la première couche conductrice (205, 305) ; et
une seconde couche conductrice (220, 315) sur la couche isolante (215, 310),
la première couche conductrice (205, 305) étant composée d'une ou de plusieurs couches d'un premier matériau de van der Waals,
la couche isolante (215, 310) étant composée d'une ou de plusieurs couches d'un deuxième matériau de van der Waals, et
la seconde couche conductrice (220, 315) étant composée d'une ou de plusieurs couches d'un troisième matériau de van der Waals.

2. Condensateur (515, 730) selon la revendication 1, comprenant également :
une couche inférieure isolante, sous la première couche conductrice (205, 305) ; et
une couche supérieure isolante, sur la seconde couche conductrice (220, 315), dans lequel :
la couche inférieure isolante étant composée d'une ou de plusieurs couches d'un premier matériau de van der Waals, et
la couche supérieure isolante étant composée d'une ou de plusieurs couches d'un premier matériau de van der Waals, comprenant également éventuellement :
une première couche de graphène, entre la première couche conductrice (205, 305) et la couche isolante (215, 310) ; et
une seconde couche de graphène, entre la couche isolante (215, 310) et la seconde couche conductrice (220, 315).

3. Condensateur (515, 730) selon l'une quelconque des revendications 1 et 2, dans lequel la première couche conductrice (205, 305) est une couche supraconductrice et la seconde couche conductrice (220, 315) est une couche supraconductrice.

4. Condensateur (515, 730) selon l'une quelconque des revendications 1 à 3, dans lequel le premier matériau de van der Waals est un matériau choisi dans le groupe constitué de NbSe₂, de MoTe₂, de WTe₂, de TaS₂, de BSCCO, du graphène et de leurs combinaisons.

5. Condensateur (515, 730) selon l'une quelconque des revendications 1 à 4, dans lequel le troisième matériau de van der Waals est le même matériau que le premier matériau de van der Waals.

6. Condensateur (515, 730) selon l'une quelconque des revendications 1 à 5, dans lequel le deuxième matériau de van der Waals est un matériau choisi dans le groupe constitué de BN, de WSe₂,
de MoS₂, de MoSe₂, de WS₂, de MoTe₂, de PtS₂, de PtSe₂, de PtTe₂, de HfS₂, de HfSe₂, de ReS₂, de ReSe₂, de SnS₃, de SnSe₂, de ZrS₂, de ZrSe₂, du silicène, du germanène, du phosphore noir et de leurs combinaisons.

7. Condensateur (515, 730) selon l'une quelconque des revendications 1 à 6, comprenant également : une première électrode, en contact avec la première couche conductrice (205, 305), et
une seconde électrode, en contact avec la seconde couche conductrice (220, 315), dans lequel éventuellement la première électrode est composée d'un matériau supraconducteur, dans lequel plus éventuellement la première électrode est composée d'un matériau choisi dans le groupe constitué de l'aluminium, du niobium, du nitrure de niobium, du nitrure de niobium-titane et du molybdène-rhénium.

8. Bit quantique, comprenant :
un condensateur (515, 730) selon la revendication 1, et
une jonction Josephson, connectée au condensateur (515, 730).

9. Bit quantique selon la revendication 8, comprenant également :
une couche inférieure isolante, sous la première couche conductrice (205, 305) ; et une couche supérieure isolante, sur la seconde couche conductrice (220, 315), dans lequel :
la couche inférieure isolante étant composée d'une ou de plusieurs couches d'un premier matériau de van der Waals, et
la couche supérieure isolante étant composée d'une ou de plusieurs couches d'un premier matériau de van der Waals.

10. Bit quantique selon l'une quelconque des revendications 8 et 9, comprenant également :
une première couche de graphène, entre la première couche conductrice (205, 305) et la couche isolante (215, 310) ; et
une seconde couche de graphène, entre la couche isolante (215, 310) et la seconde couche conductrice (220, 315), ou dans lequel la première couche conductrice (205, 305) est une couche supraconductrice et la seconde couche conductrice (220, 315) est une couche supraconductrice, ou dans lequel le premier matériau de van der Waals est un matériau choisi dans le groupe constitué de NbSe₂, de MoTe₂, de WTe₂, de TaS₂, de BSCCO, du graphène et de leurs combinaisons, ou dans lequel le troisième matériau de van der Waals est le même matériau que le premier matériau de van der Waals.

11. Bit quantique selon l'une quelconque des revendications 8 à 10, dans lequel le deuxième matériau de van der Waals est un matériau choisi dans le groupe constitué de BN, de WSe₂, de MoS₂, de MoSe₂, de WS₂, de MoTe₂, de PtS₂, de PtSe₂, de PtTe₂, de HfS₂, de HfSe₂, de ReS₂, de ReSe₂, de SnS₃, de SnSe₂, de ZrS₂, de ZrSe₂, du silicène, du germanène, du phosphore noir et de leurs combinaisons.

12. Bit quantique selon l'une quelconque des revendications 8 à 10, comprenant également :
une première électrode, en contact avec la première couche conductrice (205, 305), et une seconde électrode, en contact avec la seconde couche conductrice (220, 315).

13. Bit quantique selon la revendication 12, dans lequel la première électrode est composée d'un matériau supraconducteur.

14. Bit quantique selon la revendication 13, dans lequel la première électrode est composée d'un matériau choisi dans le groupe constitué de l'aluminium, du niobium, du nitrure de niobium, du nitrure de niobium-titane et du molybdène-rhénium.
